# EUROPÄISCHE PATENTSCHRIFT

(11) **EP 3 100 083 B1**
(45) Veröffentlichungstag und Bekanntmachung des Hinweises auf die Patenterteilung: **14.08.2019**
(21) Anmeldenummer: 15705920.5
(22) Anmeldetag: 29.01.2015
(51) Int. Cl.: G02B 5/08, G02B 5/09, G21K 1/06

(54) **VERFAHREN ZUM HERSTELLEN EINES SPIEGELELEMENTS**
METHOD FOR PRODUCING A MIRROR ELEMENT
PROCÉDÉ DE FABRICATION D'UN ÉLÉMENT DE MIROIR

(30) Priorität: 30.01.2014 DE 102014201622
(43) Veröffentlichungstag der Anmeldung: 07.12.2016
(73) Patentinhaber: Carl Zeiss SMT GmbH, 73447 Oberkochen (DE)
(72) Erfinder: ENKISCH, Hartmut, 73431 Aalen (DE); HUBER, Peter, 89518 Heidenheim (DE); STROBEL, Sebastian, 73430 Aalen (DE)
(74) Vertreter: Frank, Hartmut
(86) Internationale Anmeldenummer: PCT/EP2015/051791
(87) Internationale Veröffentlichungsnummer: WO 2015/114043

(56) Entgegenhaltungen:
- EP-A1- 1 775 604
- WO-A1-2013/077430
- DE-A1-102005 044 716
- US-A1- 2008 166 534
- US-B2- 6 898 011

## Beschreibung

### HINTERGRUND DER ERFINDUNG

### Gebiet der Erfindung

Die Erfindung betrifft ein Verfahren zum Herstellen eines Spiegelelements, insbesondere für eine mikrolithographische Projektionsbelichtungsanlage.

### Stand der Technik

Mikrolithographie wird zur Herstellung mikrostrukturierter Bauelemente, wie beispielsweise integrierter Schaltkreise oder LCD's, angewendet. Der Mikrolithographieprozess wird in einer sogenannten Projektionsbelichtungsanlage durchgeführt, welche eine Beleuchtungseinrichtung und ein Projektionsobjektiv aufweist. Das Bild einer mittels der Beleuchtungseinrichtung beleuchteten Maske (= Retikel) wird hierbei mittels des Projektionsobjektivs auf ein mit einer lichtempfindlichen Schicht (Photoresist) beschichtetes und in der Bildebene des Projektionsobjektivs angeordnetes Substrat (z.B. ein Siliziumwafer) projiziert, um die Maskenstruktur auf die lichtempfindliche Beschichtung des Substrats zu übertragen.

In für den EUV-Bereich ausgelegten Projektionsobjektiven, d.h. bei Wellenlängen von z.B. etwa 13 nm oder etwa 7 nm, werden mangels Verfügbarkeit geeigneter lichtdurchlässiger refraktiver Materialien Spiegel als optische Komponenten für den Abbildungsprozess verwendet.

In der Beleuchtungseinrichtung einer für den Betrieb im EUV ausgelegten mikrolithographischen Projektionsbelichtungsanlage ist insbesondere der Einsatz von Facettenspiegeln in Form von Feldfacettenspiegeln und Pupillenfacettenspiegeln als bündelführende Komponenten z.B. aus DE 10 2008 009 600 A1 bekannt. Derartige Facettenspiegel sind aus einer Vielzahl von Einzelspiegeln oder Spiegelfacetten aufgebaut, welche jeweils zum Zwecke der Justage oder auch zur Realisierung bestimmter Beleuchtungswinkelverteilungen über Festkörpergelenke kippbar ausgelegt sein können. Diese Spiegelfacetten können wiederum ihrerseits eine Mehrzahl von Mikrospiegeln umfassen.

Des Weiteren ist auch in einer Beleuchtungseinrichtung einer für den Betrieb bei Wellenlängen im VUV-Bereich ausgelegten mikrolithographischen Projektionsbelichtungsanlage zur Einstellung definierter Beleuchtungssettings (d.h. Intensitätsverteilungen in einer Pupillenebene der Beleuchtungseinrichtung) der Einsatz von Spiegelanordnungen, z.B. aus WO 2005/026843 A2, bekannt, welche eine Vielzahl unabhängig voneinander einstellbarer Spiegelelemente umfassen.

Ein in der Praxis auftretendes Problem ist, dass bei der Herstellung einer solchen Spiegelanordnung, z.B. eines Feldfacettenspiegels einer für den Betrieb im EUV ausgelegten Beleuchtungseinrichtung, mechanische Spannungen während des Beschichtungsvorganges (d.h. während der Aufbringung eines Schichtstapels einschließlich eines Reflexionsschichtsystems auf das Spiegelsubstrat) erzeugt werden, welche zu einer Verformung des Substrats sowie einer damit einhergehenden Beeinträchtigung der optischen Abbildungseigenschaften führen können. Zur Überwindung dieses Problems ist es bekannt, eine diese mechanische Spannung kompensierende zusätzliche Schicht auszubilden, um die gesamte mechanische Spannung innerhalb des jeweiligen Spiegelelements zu minimieren.

Des Weiteren besteht in der Praxis ein Bedarf, bei der Herstellung von Spiegelelementen die jeweilige Brechkraft des Spiegelelements möglichst exakt einzustellen (wobei es sich je nach Anwendung um eine Brechkraft von Null, entsprechend einem planen Spiegelelement, oder auch um eine von Null verschiedene Brechkraft handeln kann). Ein hierzu bekannter Ansatz besteht darin, bei der Fertigung des Spiegelelements das u.a. mit dem Reflexionsschichtsystem zu beschichtende Substrat in seiner Geometrie bereits vor Aufbringung des Schichtstapels z.B. unter Ausbildung von Asphären, Feinkorrekturen etc. entsprechend der gewünschten "Endspezifikation" des Spiegelelements auszugestalten und im Anschluss daran den Beschichtungsprozess (d.h. die Aufbringung des Schichtstapels einschließlich des Reflexionsschichtsystems) z.B. unter Einsatz der vorstehend genannten Spannungskompensation so durchzuführen, dass die Form des Substrats bei der Beschichtung nicht mehr geändert wird.

Zum Stand der Technik wird lediglich beispielhaft auf WO 2004/029692 A2, DE 10 2009 033 511 A1, DE 10 2008 042 212 A1, US 6,011,646 A, US 2008/0166534 A1, US 7,056,627 B2, WO 2013/077430 A1 sowie DE 10 2005 044 716 A1 verwiesen.

### ZUSAMMENFASSUNG DER ERFINDUNG

Es ist eine Aufgabe der vorliegenden Erfindung, ein Verfahren zum Herstellen eines Spiegelelements, insbesondere für eine mikrolithographische Projektionsbelichtungsanlage, bereitzustellen, welches die Erzeugung einer gewünschten Brechkraft mit möglichst geringem fertigungstechnischem Aufwand ermöglicht.

Diese Aufgabe wird durch Verfahren gemäß den Merkmalen des unabhängigen Patentanspruchs 1 gelöst.

Ein erfindungsgemäßes Verfahren zum Herstellen eines Spiegelelements weist folgende Schritte auf:
- Bereitstellen eines Substrats; und
- Ausbilden eines Schichtstapels auf dem Substrat, wobei dieser Schichtstapel zumindest ein Reflexionsschichtsystem aufweist;
- wobei das Ausbilden des Schichtstapels derart erfolgt, dass eine für eine vorgegebene Betriebstemperatur gewünschte Soll-Krümmung des Spiegelelements durch eine von dem Schichtstapel ausgeübte Biegekraft erzeugt wird, wobei das Substrat vor dem Ausbilden des Schichtstapels eine von dieser Soll-Krümmung des Spiegelelements abweichende Krümmung besitzt, und wobei die von dem Schichtstapel ausgeübte Biegekraft zumindest teilweise dadurch erzeugt wird, dass eine Nachbehandlung zur Veränderung der Schichtspannung des Schichtstapels durchgeführt wird;

- wobei jeweils eine Mehrzahl von Spiegelelementen hergestellt wird, wobei sich wenigstens zwei dieser Spiegelelemente in der Soll-Krümmung voneinander unterscheiden; und
- wobei die Herstellung der Spiegelelemente mit voneinander verschiedener Soll-Krümmung dadurch erfolgt, dass entweder auf Substraten unterschiedlicher Dicke jeweils ein Schichtstapel unter Einstellung der gleichen, von dem jeweiligen Schichtstapel ausgeübten Biegekraft aufgebracht wird, oder dass auf Substraten gleicher Dicke jeweils ein Schichtstapel unter Einstellung unterschiedlicher, von dem jeweiligen Schichtstapel ausgeübter Biegekräfte aufgebracht wird.

Der Erfindung liegt insbesondere das Konzept zugrunde, die bei Herstellung eines Spiegelelements während der Aufbringung eines Schichtstapels einschließlich eines Reflexionsschichtsystems auf ein Substrat erzeugte mechanische Spannung nicht etwa durch eine zusätzliche, dieser mechanischen Spannung entgegenwirkende Kompensationsschicht (oder ein dieser mechanischen Spannung entgegenwirkendes Kompensationsschichtsystem) zu eliminieren, sondern vielmehr die während der Aufbringung des Schichtstapels einschließlich des Reflexionsschichtsystems auf das Substrat erzeugte mechanische Spannung und die hierdurch von dem Schichtstapel auf das Substrat ausgeübte Biegekraft gezielt zur Erzeugung einer gewünschten Soll-Krümmung des Spiegelelements - und damit einer gewünschten endlichen Brechkraft des Spiegelelements - zu nutzen. Dabei besitzt das Substrat vor dem Ausbilden des Schichtstapels eine von der gewünschten Soll-Krümmung des Spiegelelements abweichende Krümmung.

Die Erfindung beinhaltet insbesondere eine bewusste Abkehr von herkömmlichen Ansätzen, bei denen zur Fertigung eines Spiegelelements zunächst das Substrat durch geeignete Bearbeitungsschritte (z.B. im Wege der Ausbildung von Asphären, Feinkorrekturen etc.) entsprechend der gewünschten "Endspezifikation" des Spiegelelements ausgestaltet und anschließend bei der Aufbringung des Schichtstapels einschließlich des Reflexionsschichtsystems dafür gesorgt wird, dass die betreffende, bereits gezielt vorgegebene Spiegelsubstratform unter Ausnutzung spannungskompensierender Schicht(en) beibehalten wird.

Vielmehr beinhaltet die vorliegende Erfindung das Prinzip, bei der Fertigung eines Spiegelelements von einer Form bzw. Geometrie des Substrats vor Aufbringung des das Reflexionsschichtsystem beinhaltenden Schichtstapels auszugehen, welche noch nicht der letztendlich für das fertige Spiegelelement gewünschten Krümmung entspricht, um dann unter Ausnutzung der bei Aufbringung des Schichtstapels einschließlich des Reflexionsschichtsystems erzeugten mechanischen Spannung das Substrat bewusst zu verformen. Der sich letztendlich ergebende Krümmungsradius des Substrats und damit die Brechkraft des fertigen Spiegelelements wird somit als Ergebnis aus der ursprünglichen Form bzw. Geometrie (einschließlich der Dicke) des Substrats sowie den bei der Aufbringung des Schichtstapels einschließlich des Reflexionsschichtsystems eingestellten Parametern (ggf. wie im Weiteren erläutert unter zusätzlicher Ausnutzung einer Nachbehandlung) erzielt.

Gemäß einer Ausführungsform wird durch die von dem Schichtstapel ausgeübte Biegekraft, insbesondere durch die Nachbehandlung zur Veränderung der Schichtspannung des Schichtstapels, eine irreversible Änderung der Krümmung bewirkt.

Die Nachbehandlung zur Veränderung der Schichtspannung des Schichtstapels kann insbesondere eine thermische Nachbehandlung, z.B. durch Heizbestrahlung, Laserbestrahlung oder Tempern, umfassen (wobei die Nachbehandlung noch vor dem Betrieb des optischen Systems bzw. der Projektionsbelichtungsanlage, also noch bei der Herstellung des betreffenden Spiegelelementes, erfolgt). Des Weiteren kann die Nachbehandlung alternativ oder zusätzlich eine Ionenbestrahlung oder Elektronenbestrahlung umfassen. Die Nachbehandlung kann ferner auf einen oder mehrere Teilbereiche des Schichtstapels (die in ihrer Gesamtheit kleiner als die gesamte Ausdehnung bzw. Fläche des Schichtstapels sind) lokal begrenzt werden, um z.B. Eck- oder Randbereiche eines Spiegelelements in anderer Weise als den übrigen Bereich des betreffenden Spiegelelements nachzubehandeln.

Gemäß einer Ausführungsform weist das Substrat eine lokal variierende Steifigkeit auf, welche so gewählt ist, dass nach dem Ausbilden des Schichtstapels die für die vorgegebene Betriebstemperatur gewünschte Soll-Krümmung des Spiegelelements erzielt wird.

Gemäß einer Ausführungsform wird die Steifigkeit zumindest teilweise durch ein variierendes Dickenprofil des Substrats bewirkt.

Zur Variation des Dickenprofils des Substrats können geeignete, Material abtragende oder auch Material hinzufügende Verfahren eingesetzt werden. Die Materialabtragung kann z.B. durch Ätzen oder durch lonenstrahlbearbeitung (IBF = "ion beam figuring") oder auch beliebige andere geeignete Verfahren zur Materialabtragung erfolgen. Die Materialhinzufügung kann z.B. ein SputterVerfahren, eine Elektronenstrahl-Aufdampfung oder beliebige andere Verfahren zur Materialaufbringung umfassen.

Gemäß einer Ausführungsform ist das Substrat aus einem ersten Material hergestellt, wobei die Steifigkeit zumindest teilweise durch Dotierung mit Fremdatomen eines von dem ersten Material verschiedenen zweiten Materials bewirkt wird. Des Weiteren ist z.B. auch eine Ionenimplantation möglich. Solche dotierten oder implantierten Fremdatome bzw. -ionen können beispielsweise Sauerstoff, Stickstoff, Fluor oder Wasserstoffatome bzw. -ionen sein.

Weitere Möglichkeiten zur Steifigkeitsbeeinflussung sind eine gezielte, bereichsweise herbeigeführte chemische Veränderung z.B. durch Oxidieren oder Nitridieren des Substratmaterials, z.B. eine im Oberflächenbereich gezielt verstärkte chemische Umwandlung von Silizium als Substratmaterial zu Siliziumdioxid (SiO₂) oder Siliziumnitrid (Si₃N₄), oder auch eine Laserbehandlung. Dabei kann alternativ zu einer gezielte Veränderung der chemischen Struktur (Oxidation, etc.) auch eine Veränderung der Morphologie (z.B. Phase oder Kristallorientierung) erreicht werden.

Gemäß einer Ausführungsform wird die Steifigkeit zumindest teilweise durch eine die Steifigkeit beeinflussende Struktur oder Schicht bewirkt, welche insbesondere auf der zum Schichtstapel entgegengesetzten Seite des Substrats angeordnet sein kann. Eine solche Struktur kann z.B. zusätzliche Lamellen auf der dem Reflexionsschichtstapel abgewandten Seite des Substrats ("Substratrückseite") umfassen, oder auch eine zusätzliche, die Steifigkeit beeinflussende Schicht. In weiteren Ausführungsformen kann eine solche Struktur bzw. Schicht auch auf der Substratvorderseite bzw. der dem Reflexionsschichtstapel zugewandten Seite des Substrats angeordnet sein. Des Weiteren können in Ausführungsformen in einer solchen Struktur verbleibende Zwischenräume etwa zwischen Lamellen mit einem anderen Material, oder auch mit demselben Material mit abweichender Orientierung, Dichte etc., wieder aufgefüllt werden, um beispielsweise eine homogene bzw. glatte Oberfläche zu erreichen.

Gemäß einer Ausführungsform ist das Substrat vor dem Ausbilden des Schichtstapels plan oder konvex gekrümmt.

Gemäß einer Ausführungsform weist der Schichtstapel zwischen dem Reflexionsschichtsystem und dem Substrat eine zusätzliche spannungsinduzierende Schicht auf. Eine solche zusätzliche spannungsinduzierende Schicht kann als Schicht aus einem metallischen Material wie Nickel, Titan etc. oder auch z.B. als (weiterer) Molybdän-Silizium-Stapel mit einem hohen Γ-Wert von z.B. mehr als 0.5 (wobei der Γ-Wert wie weiter unten definiert das Verhältnis aus Absorberlagendicke zur Gesamtdicke einer Periode des betreffenden Schichtstapels angibt) hergestellt sein und gezielt so ausgestaltet werden, dass im Ergebnis die gewünschte mechanische Spannung im Schichtsystem erzeugt wird. Die Erfindung ist jedoch hierauf nicht beschränkt, so dass gegebenenfalls die gewünschte mechanische Spannung im Schichtsystem auch allein durch die geeignete Ausgestaltung des Reflexionsschichtsystems erzeugt werden kann.

Grundsätzlich ist zu beachten, dass die Krümmung, welche das Substrat bzw. Spiegelelement aufweist, temperaturabhängig ist, wobei eine bei einer vorgegebenen Temperatur konkave Krümmung beispielsweise mit zunehmender Temperatur in eine konvexe Krümmung übergehen kann. Die mittels des erfindungsgemäßen Verfahrens erzeugte Krümmung bzw. Brechkraft des fertigen Spiegelelements wird unter Berücksichtigung dieser Temperaturabhängigkeit so erzeugt, dass sich die gewünschte (z.B. konkave) Krümmung eben bei der vorgegebenen Betriebstemperatur ergibt.

Gemäß einer Ausführungsform ist für eine Betriebstemperatur von wenigstens 100°C die gewünschte Soll-Krümmung des Spiegelelements eine konkave Krümmung.

Gemäß einer Ausführungsform wird jeweils unter Durchführung der o.g. Schritte eine Mehrzahl von Spiegelelementen hergestellt, wobei sich wenigstens zwei dieser Spiegelelemente in der Soll-Krümmung voneinander unterscheiden.

Gemäß einer Ausführungsform erfolgt die Herstellung der Spiegelelemente mit voneinander verschiedener Soll-Krümmung dadurch, dass auf Substraten unterschiedlicher Dicke jeweils ein Schichtstapel unter Einstellung der gleichen, von dem jeweiligen Schichtstapel ausgeübten Biegekraft aufgebracht wird.

Gemäß einer Ausführungsform erfolgt die Herstellung der Spiegelelemente mit voneinander verschiedener Soll-Krümmung dadurch, dass auf Substraten gleicher Dicke jeweils ein Schichtstapel unter Einstellung unterschiedlicher, von dem jeweiligen Schichtstapel ausgeübter Biegekräfte aufgebracht wird.

Gemäß einer Ausführungsform ist das Spiegelelement ein Spiegelelement einer aus einer Mehrzahl von Spiegelelementen zusammengesetzten Spiegelanordnung. Diese Spiegelelemente können insbesondere unabhängig voneinander verkippbar sein.

Gemäß einer Ausführungsform ist die Spiegelanordnung ein Facettenspiegel, insbesondere ein Feldfacettenspiegel oder ein Pupillenfacettenspiegel.

Gemäß einer Ausführungsform ist das Spiegelelement für eine Arbeitswellenlänge von weniger als 30 nm, insbesondere weniger als 15 nm, ausgelegt. Die Erfindung ist jedoch hierauf nicht beschränkt, so dass in weiteren Anwendungen das Spiegelelement auch für eine Wellenlänge im VUV-Bereich, insbesondere eine Wellenlänge von weniger als 200nm, ausgelegt sein kann.

Gemäß einer Ausführungsform ist das Spiegelelement ein Spiegelelement einer mikrolithographischen Projektionsbelichtungsanlage. Die Erfindung ist jedoch nicht hierauf beschränkt, sondern auch z.B. in Messaufbauten, die insbesondere für den Betrieb im EUV ausgelegt sein können, realisierbar.

In Ausführungsformen kann im Betrieb des optischen Systems, insbesondere der mikrolithographischen Projektionsbelichtungsanlage, zusätzlich noch eine Nachregelung der Krümmung des betreffenden Spiegelelements bzw. der Spiegelelemente durch Einstellung der Temperatur des betreffenden Spiegelelements vorgenommen werden. Mit anderen Worten kann in Ausführungsformen der Erfindung während des Betrieb des optischen Systems (insbesondere der Projektionsbelichtungsanlage) noch eine Anpassung der Krümmung bzw. Brechkraft der einzelnen Spiegelelemente durch ein (insbesondere inhomogenes) Aufheizen des betreffenden Spiegelelements (oder der Spiegelelemente der Spiegelanordnung) erfolgen, wobei die Krümmung des betreffenden Spiegelelements je nach der in der entsprechenden Position vorliegenden Betriebstemperatur variiert. Dabei kann eine Nachregelung der Krümmung bzw. Brechkraft der einzelnen Spiegelelemente dadurch erfolgen, dass die Temperatur der betreffenden Spiegelelemente bzw. Mikrospiegel vorgegeben und eingestellt bzw. geregelt wird. Insbesondere kann z.B. über die zuvor beschriebene, erfindungsgemäße Ausbildung des Reflexionsschichtstapels unter Ausnutzung der Biegekraft zunächst eine Grobeinstellung der Krümmung bzw. Brechkraft und über die zuletzt genannte Temperatureinstellung eine Feineinstellung ("Feintuning") durchgeführt werden.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

### KURZE BESCHREIBUNG DER ZEICHNUNGEN

Es zeigen:
- Figur 1-5: schematische Darstellungen zur Erläuterung möglicher Ausführungsformen eines erfindungsgemäßen Verfahrens;
- Figur 6-7: schematische Darstellungen zur Erläuterung des möglichen Aufbaus einer für den Betrieb im EUV ausgelegten mikrolithographischen Projektionsbelichtungsanlage; und
- Figur 8-10: schematische Darstellungen zur Erläuterung weiterer möglicher Ausführungsformen der Erfindung.

### DETAILLIERTE BESCHREIBUNG BEVORZUGTER AUSFÜHRUNGSFORMEN

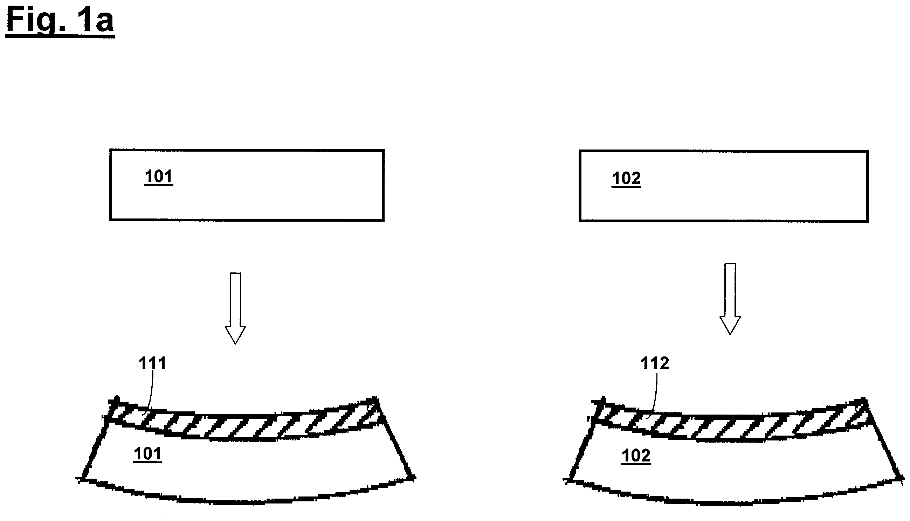

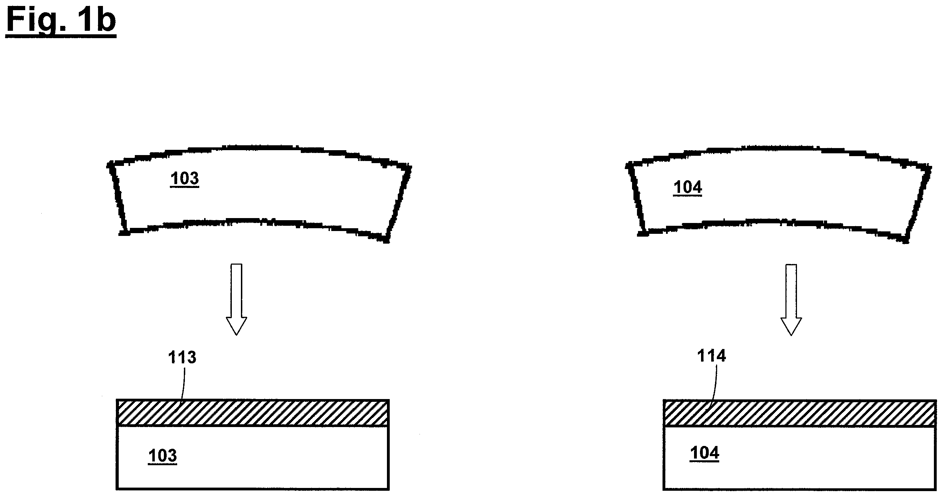

Im Weiteren werden zunächst unter Bezugnahme auf Fig. 1-5 mögliche Ausführungsformen eines erfindungsgemäßen Verfahrens zur Herstellung eines Spiegelelements beschrieben. Bei den hergestellten Spiegelelementen kann es sich (ohne dass die Erfindung hierauf beschränkt wäre) z.B. um Spiegelelemente oder Mikrospiegel einer Spiegelanordnung in Form eines Feldfacettenspiegels handeln, wobei die einzelnen Spiegelelemente identische oder auch voneinander verschiedene Krümmungen bzw. Brechkraft aufweisen können.

In sämtlichen Ausführungsformen wird jeweils ein Schichtstapel, welcher ein Reflexionsschichtsystem (z.B. als Vielfachschichtsystem aus Molybdän- und Siliziumschichten) aufweist, auf einem Substrat aufgebracht. Bei dem Spiegelsubstratmaterial kann es sich z.B. um Silizium (Si) oder um Titandioxid (TiO₂)-dotiertes Quarzglas handeln, wobei beispielhaft die unter den Markenbezeichnungen ULE® (der Firma Corning Inc.) oder Zerodur® (der Firma Schott AG) vertriebenen Materialien verwendbar sind. In weiteren Ausführungsformen kann das Spiegelsubstratmaterial auch Germanium (Ge), Diamant, Galliumarsenid (GaAs), Galliumnitrid (GaN), Galliumantimonid (GaSb), Galliumphosphid (GaP), Al₂O₃, Indiumphosphid (InP), Indiumarsenid (InAs), Indiumantimonid (InSb), Kalziumfluorid (CaF₂), Zinkoxid (ZnO) oder Siliziumkarbid (SiC) aufweisen. Optional können noch weitere Funktionsschichten, wie beispielsweise eine Deckschicht ("Cap-Layer"), eine Substratschutzschicht etc. in für sich bekannter Weise vorgesehen sein.

Den unter Bezugnahme auf Fig. 1 bis Fig. 5 beschriebenen Ausführungsbeispielen ist gemeinsam, dass jeweils bei der Ausbildung des das Reflexionsschichtsystem umfassenden Schichtstapels auf dem Substrat eine von Null verschiedene Biegekraft des Schichtstapels durch geeignete Einstellung der Beschichtungsparameter und/oder der Parameter einer Nachbehandlung und der hierdurch erzeugten mechanischen Spannung ausgeübt wird.

Die Einstellung der mechanischen Spannung bei Ausbildung des jeweiligen Schichtstapels erfolgt erfindungsgemäß in für sich bekannter Weise dadurch, dass insbesondere im Reflexionsschichtsystem Materialien und Dickenverhältnisse (z.B. das Verhältnis aus Absorberlagendicke zur Gesamtdicke einer Periode, wobei dieses Dickenverhältnis auch als Γ bezeichnet wird) in gewünschter Weise eingestellt werden. Die Vorgehensweise bei der Einstellung einer mechanischen Spannung ist dem Fachmann z.B. aus DE 10 2008 042 212 A1 bekannt. Des Weiteren kann die Einstellung der mechanischen Spannung bei Aufbringung des jeweiligen Schichtstapels auch durch Sauerstoffdotierung bzw. Zugabe von Sauerstoff beim Beschichten erfolgen, wie es dem Fachmann aus DE 10 2011 003 357 A1 bekannt ist.

Diese während der Ausbildung des das Reflexionsschichtsystem umfassenden Schichtstapels auf dem Substrat erzeugte mechanische Spannung führt dazu, dass die Krümmung des Substrats im Vergleich zur ursprünglichen Krümmung, welche im Zustand vor der Beschichtung vorgelegen hat, verändert wird. Die besagte ursprüngliche Krümmung des Substrats im Zustand vor der Beschichtung kann entweder Null betragen (d.h. das Substrat ist vor der Beschichtung plan), oder die ursprüngliche Krümmung kann einer noch nicht der gewünschten Soll-Krümmung des fertigen Spiegelelements entsprechenden endlichen Krümmung (z.B. einer konvexen Krümmung) entsprechen.

Die einzelnen Ausführungsformen von Fig. 1-5 unterscheiden sich durch die Art und Weise, in welcher die verschiedenen Spiegelelemente (z.B. einer Spiegelanordnung wie eines Feldfacettenspiegels) je nach Ausgangsform bzw. ursprünglicher Krümmung des Substrats im Zustand vor der Beschichtung, Einstellung der Beschichtungsparameter im Hinblick auf die hierbei erzeugte mechanische Spannung sowie gegebenenfalls (z.B. thermische) Nachbehandlung mit identischer oder unterschiedlicher Krümmung gefertigt werden.

Gemäß Fig. 1a kann z.B. eine Mehrzahl von Spiegelelementen gleicher Krümmung bzw. Brechkraft dadurch hergestellt werden, dass im Ausgangszustand plane (Spiegel-)Substrate 101, 102,... jeweils mit einem ein Reflexionsschichtsystem umfassenden Schichtstapel 111, 112,... unter Einstellung jeweils identischer Beschichtungsparameter beschichtet werden, wobei während dieser Beschichtung die erzeugte mechanische Spannung und die hieraus resultierende Biegekraft auf das jeweilige Substrat 101, 102,... derart gewählt werden, dass sich im jeweils fertigen Spiegelelement die gewünschte (für die einzelnen Spiegelelemente jeweils identische) Krümmung einstellt.

Gemäß Fig. 1b können die jeweiligen Substrate 103, 104,... auch im Ausgangszustand (vor der Beschichtung) eine endliche Krümmung aufweisen, die noch nicht der letztlich gewünschten Krümmung entspricht, wobei diese Substratkrümmung dann durch die bei Aufbringung des Schichtstapels erzeugte mechanische Spannung bzw. ausgeübte Biegekraft verändert wird. Konkret wird im Beispiel von Fig. 1b eine im Ausgangszustand vor der Beschichtung konvexe Krümmung der Substrate 103, 104,... auf Null gebracht, also letztendlich eine plane Geometrie der fertigen Spiegelelemente erzeugt.

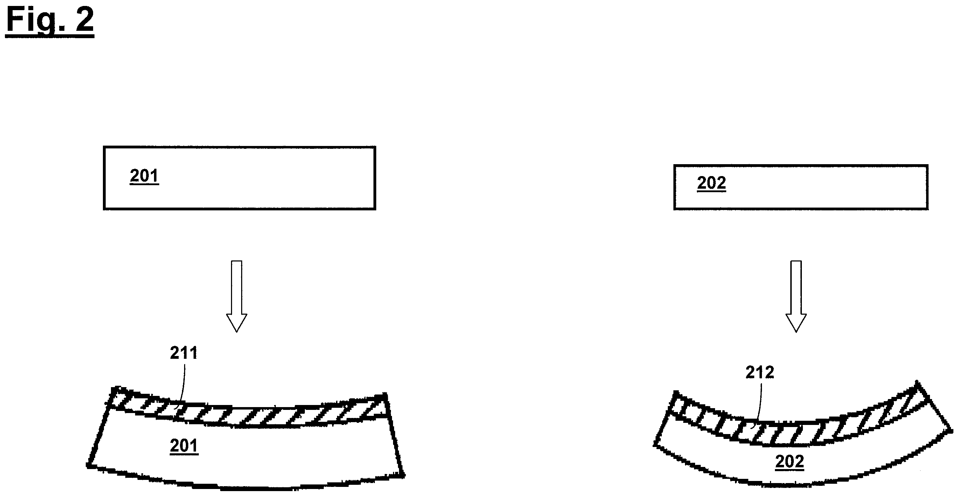

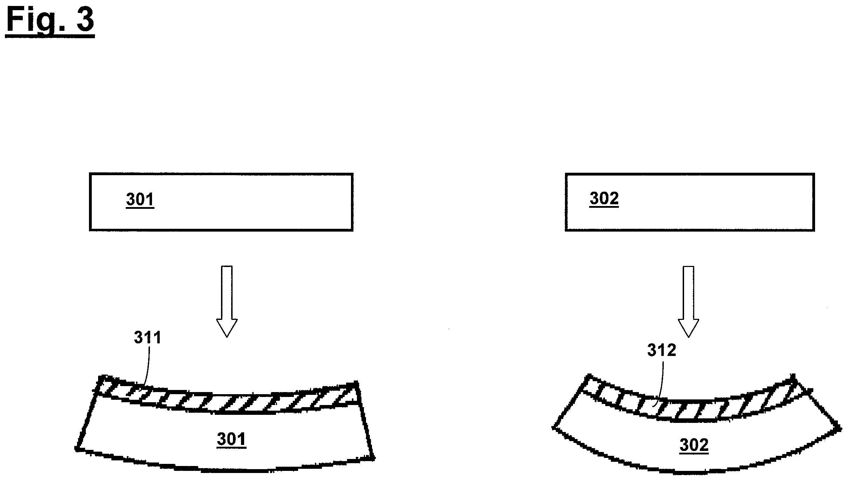

Fig. 2 und 3 dienen zur Erläuterung möglicher weiterer Ausführungsbeispiele für die Herstellung einer Mikrospiegelanordnung z.B. in Form eines Feldfacettenspiegels, in welchem einzelne Spiegelelemente voneinander verschiedene Krümmungen bzw. unterschiedliche Brechkraft aufweisen sollen. Hierbei sind im Vergleich zu Fig. 1 analoge bzw. im Wesentlichen funktionsgleiche Komponenten in Fig. 2 mit um "100" erhöhten Bezugsziffern und in Fig. 3 mit um "200" erhöhten Bezugsziffern bezeichnet.

Zur Erzeugung unterschiedlicher Krümmungen in den letztlich gefertigten Spiegelelementen werden gemäß Fig. 2 wiederum plane Substrate 201, 202,..., welche jedoch voneinander verschiedene Dicken aufweisen, mit jeweils einem Schichtstapel unter Einstellung der gleichen mechanischen Spannung bzw. Biegekraft beschichtet. Wie im unteren Teil von Fig. 2 angedeutet ist, führt dies infolge der unterschiedlichen Substratdicken zur Erzeugung unterschiedlicher Krümmungen der fertigen Spiegelelemente (wobei gemäß Fig. 2 die erzeugte Krümmung bei geringerer Substratdicke größer ist).

Gemäß Fig. 3 erfolgt die Erzeugung unterschiedlicher Krümmungen in den letztendlich gefertigten Spiegelelementen gewissermaßen umgekehrt zu Fig. 2 dadurch, dass (im Beispiel wiederum plane) Substrate 301, 302,... gleicher Dicke mit Schichtstapeln 311, 312,... unter Erzeugung unterschiedlicher mechanischer Spannungen bzw. Biegekräfte beschichtet werden. Wie aus dem unteren Teil von Fig. 3 ersichtlich ist, hat hierbei die Einstellung einer höheren Schichtspannung (rechter Teil von Fig. 3) eine größere Krümmung in dem letztendlich gefertigten Spiegelelement zur Folge. In anderen Ausführungsbeispielen (bei einem Ausgangszustand mit unterschiedlich großer konvexer Krümmung) kann eine höhere Schichtspannung auch im Endzustand zu einer vergleichsweise kleineren Krümmung führen.

In weiteren Ausführungsformen der Erfindung können auch Spiegelelemente mit voneinander verschiedener Krümmung dadurch erzeugt werden, dass einzelne Substrate mit im Ausgangszustand (d.h. vor der Beschichtung) gleicher Dicke und Geometrie einer Beschichtung (d.h. Aufbringung des Schichtstapels einschließlich des Reflexionsschichtsystems) mit identischen Parametern (unter Erzeugung der gleichen mechanischen Spannung) unterzogen werden, dann jedoch im Anschluss eine (insbesondere thermische) Nachbehandlung durchgeführt wird, durch welche die jeweils in den Schichtstapeln der einzelnen Spiegelelemente erzeugte mechanische Spannung nachträglich verändert wird. Eine solche Nachbehandlung kann z.B. das Tempern in einem Ofen (unter Einstellung einer definierten Atmosphäre), eine thermische Nachbehandlung unter Verwendung eines Heizstrahlers, oder auch eine Nachbehandlung unter Laserbestrahlung, Ionenbestrahlung oder Elektronenbestrahlung (sowie auch Kombinationen aus diesen Verfahren) umfassen. Hierbei kann erforderlichenfalls von der Spiegelrückseite her eine geeignete Kühlung durchgeführt werden. Zur gezielten Nachbehandlung einzelner lokaler Bereiche eines Spiegelelements ist insbesondere die Laserbestrahlung (gegebenenfalls unter Verwendung einer nur die der Nachbehandlung zu unterziehenden Bereiche wie z.B. Ecken des Spiegelelements freilegenden Maske) geeignet. Auf diese Weise können z.B. Eck- oder Randbereiche eines Spiegelelements in anderer Weise als der übrige Bereich des betreffenden Spiegelelements nachbehandelt bzw. verformt werden. Des Weiteren kann die vorstehend beschriebene Nachbehandlung entweder für sämtliche gefertigte Spiegelelemente in identischer Weise, für einzelne Spiegelelemente (oder auch größere Einheiten von jeweils einer Mehrzahl von Spiegelelementen in Form von Spiegelarrays) individuell oder auch wie vorstehend beschrieben über einzelne Spiegelelemente lokal variierend erfolgen.

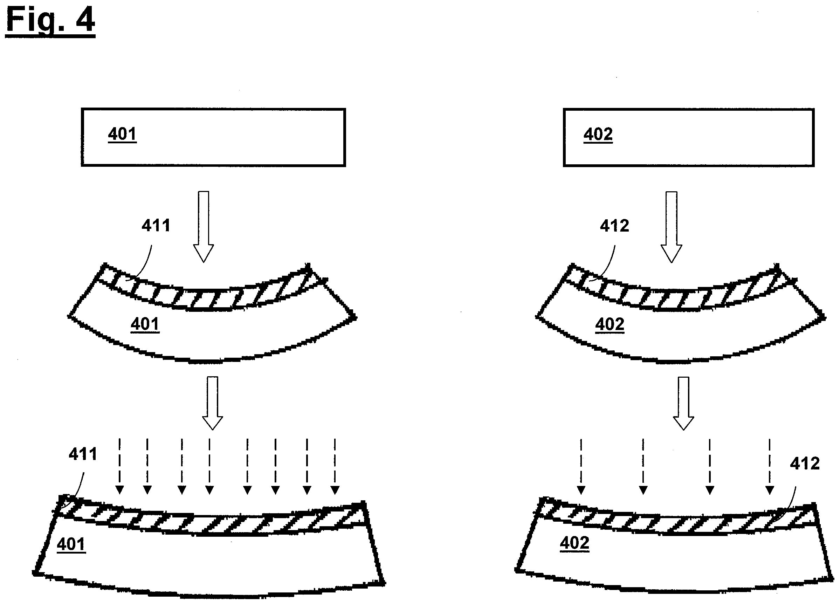

Fig. 4 zeigt zur Veranschaulichung dieses Prinzips, wie eine zunächst einheitliche bzw. identische Beschichtung von Substraten 401, 402,... mit jeweils einem Schichtstapel 411, 412,... zunächst zu einer identischen Krümmung (mittlerer Teil von Fig. 4), dann jedoch im Wege unterschiedlicher Nachbehandlungen zu unterschiedlicher Krümmung bzw. Brechkraft der jeweils gefertigten Spiegelelemente führt.

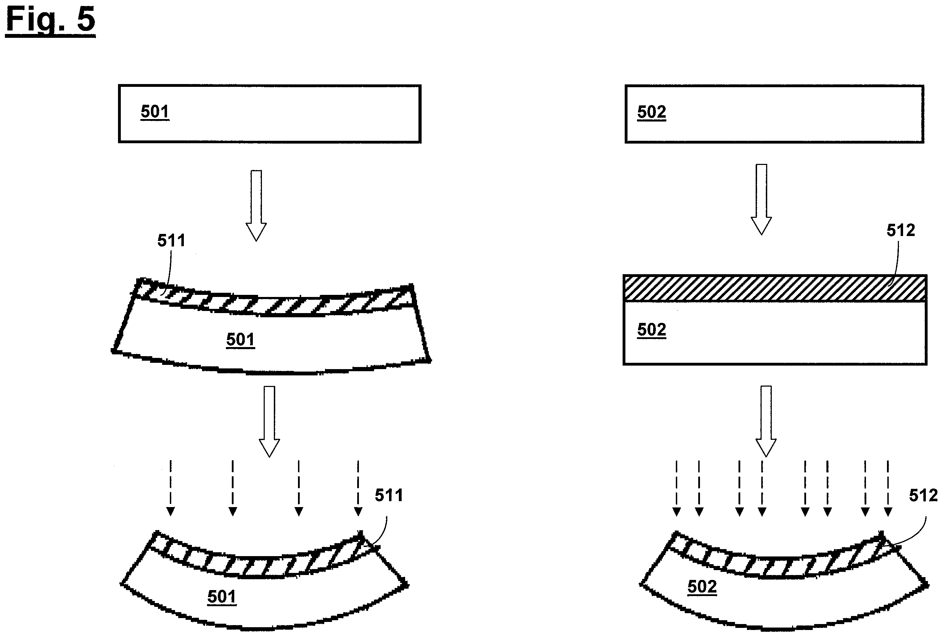

Wie in Fig. 5 schematisch dargestellt ist, kann die vorstehend beschriebene Nachbehandlung auch dazu eingesetzt werden, eine nach Ausbildung des Schichtstapels einschließlich des Reflexionsschichtsystems auf dem Substrat zunächst erzeugte oder auch bereits vor der Beschichtung vorliegende unerwünschte (z.B. inhomogene bzw. für eine Mehrzahl von Substraten 501, 502,... variierende) Krümmung, wie sie z.B. aus Prozessschwankungen in den einzelnen Beschichtungsprozessen resultieren kann, zu "homogenisieren" mit der Folge, dass die letztendlich gefertigten Spiegelelemente die gleiche Krümmung bzw. Brechkraft besitzen.

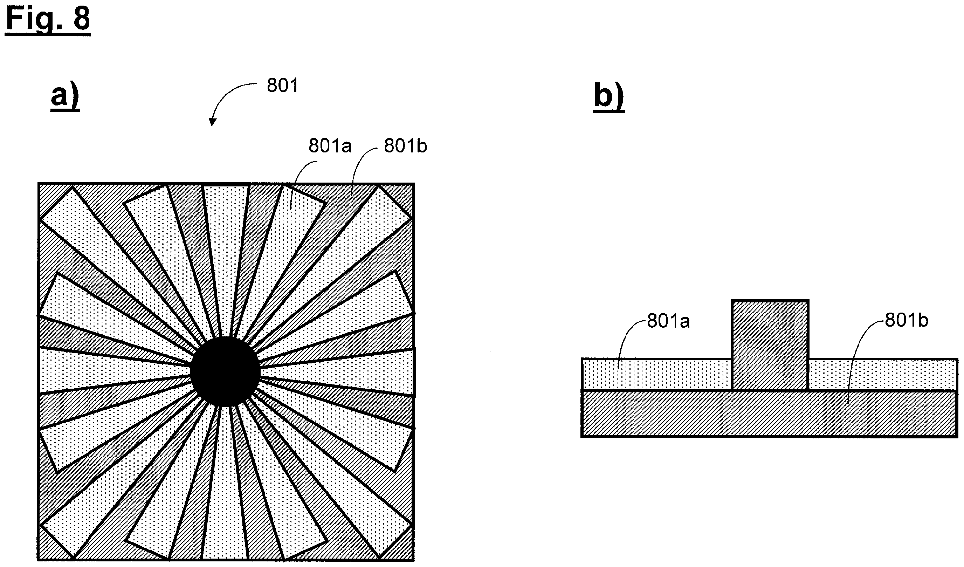

Im Weiteren werden unter Bezugnahme auf Fig. 8-10 Ausführungsformen der Erfindung beschrieben, bei denen zusätzlich zu den vorstehend anhand von Fig. 1-5 beschriebenen Verfahrensschritten eine gezielte Beeinflussung der Steifigkeit des Substrats vor dem Aufbringen des Schichtstapels einschließlich des Reflexionsschichtsystems vorgenommen wird. Auch in den Ausführungsformen gemäß Fig. 8-10 kann es sich bei dem betreffenden Spiegelelement insbesondere um ein Spiegelelement einer Mikrospiegelanordnung, z.B. eines Feldfacettenspiegels, handeln.

Diesem Ansatz liegt die Überlegung zugrunde, dass eine gezielte Beeinflussung der Steifigkeit des Substrats dessen "Reaktion" auf die von dem Schichtstapel einschließlich des Reflexionsschichtsystems ausgeübte Biegekraft bestimmt und damit ebenfalls dazu geeignet ist, letztendlich eine erwünschte Oberflächengeometrie bzw. Soll-Krümmung des Spiegelelements herbeizuführen bzw. hierzu beizutragen.

In den in Fig. 8-10 lediglich schematisch dargestellten Ausführungsformen erfolgt die vorstehende, gezielte Steifigkeitsbeeinflussung des Substrats dadurch, dass eine Material abtragende oder Material hinzufügende Bearbeitung des Substrats durchgeführt wird.

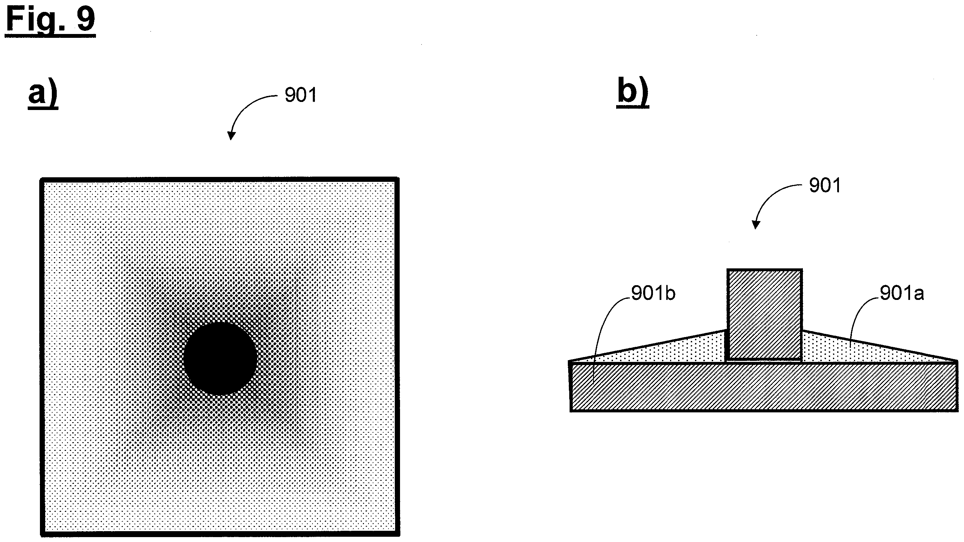

Gemäß Fig. 8a (Rückansicht) und Fig. 8b (Querschnitt) wurde ein Substrat 801 in einer Vielzahl von (lediglich beispielhaft speichenförmig angeordneten) Bereichen 801a z.B. mittels Ätzen gedünnt, so dass es in den verbleibenden Bereichen 801b eine vergleichsweise größere Dicke aufweist. Fig. 9a und 9b zeigen in Rückansicht (Fig. 9a) bzw. Querschnitt (Fig. 9b) lediglich beispielhaft eine weitere Ausführungsform eines Substrats 901 mit in radialer Richtung kontinuierlichem Dickenabtrag. In weiteren Ausführungsformen kann eine kontinuierliche Dickenvariation gemäß Fig. 9b auch mit der Ausgestaltung von Fig. 8a (d.h. der entsprechenden Geometrie der jeweiligen Bereiche in Rückansicht) kombiniert werden, oder es kann die Dickenvariation gemäß Fig. 8b mit der Ausgestaltung gemäß Fig. 9a (d.h. der entsprechenden Geometrie der jeweiligen Bereiche in Rückansicht) kombiniert werden, etc.

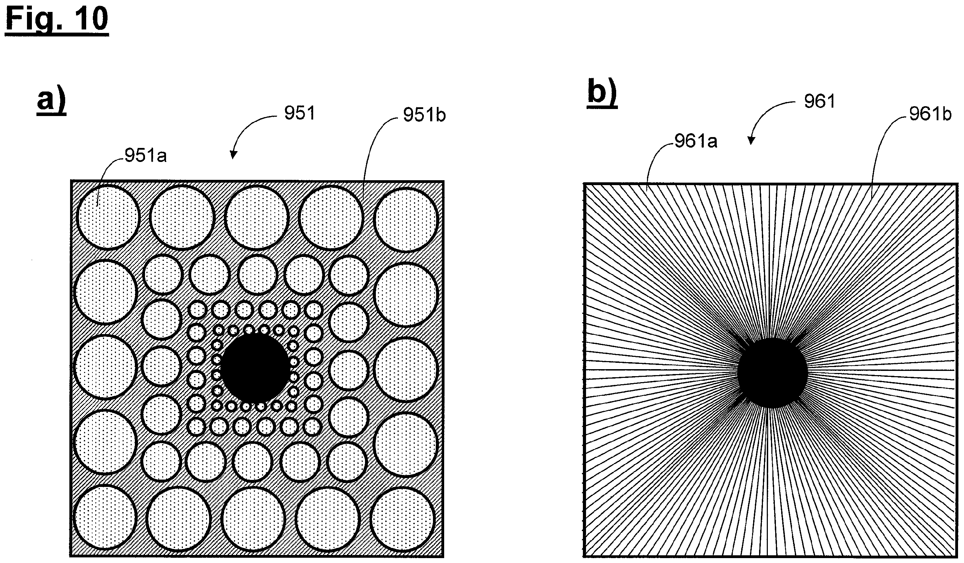

Fig. 10a und 10b zeigen ebenfalls lediglich beispielhaft weitere Ausgestaltungen, wobei in Fig. 10a ein Substrat 951 in kreisförmigen Bereichen 951a unterschiedlicher Größe gedünnt wurde (wiederum zur Erzeugung von Bereichen 951a bzw. 951b unterschiedlicher Dicke), und wobei gemäß Fig. 10b ein Substrat 961 mit in radialer Richtung angeordneten, dünnen Stegen (als Bereiche 961b größerer Dicke, zwischen denen sich somit ebenfalls relativ dünnere Bereiche 961a befinden) versehen wurde.

Die Erfindung ist hinsichtlich der Steifigkeitsbeeinflussung des Substrats nicht auf eine Material abtragende oder Material hinzufügende Bearbeitung des Substrats beschränkt. So kann in weiteren Ausführungsformen die Steifigkeitsbeeinflussung des Substrats zumindest teilweise auch durch Dotierung mit Fremdatomen oder Ionenimplantation (z.B. von Sauerstoff-, Stickstoff-, Fluor- oder Wasserstoffatomen bzw. -ionen), durch chemische Umwandlung, Laserbehandlung oder auch durch eine die Steifigkeit beeinflussende Struktur (z.B. in Form von Lamellen) bewirkt werden, welche insbesondere auf der zum Schichtstapel entgegengesetzten Seite des Substrats ("Substratrückseite") angeordnet sein kann. Eine Anordnung auf der dem Schichtstapel zugewandten Seite des Substrats ("Substratvorderseite") ist ebenfalls möglich, wobei dafür Sorge zu tragen ist, dass die gewünschten optischen Eigenschaften nicht beeinträchtigt werden.

In Ausführungsformen können die jeweiligen Zwischenräume in einer Struktur, z.B. zwischen Lamellen, mit einem anderen Material oder auch mit demselben Material mit abweichender Orientierung, Dichte etc. wieder aufgefüllt werden, um beispielsweise eine homogene bzw. glatte Oberfläche zu erreichen.

In weiteren Ausführungsformen kann auch auf der dem Reflexionsschichtstapel abgewandten Seite des Substrats eine zusätzliche, die Steifigkeit beeinflussende Schicht vorgesehen sein.

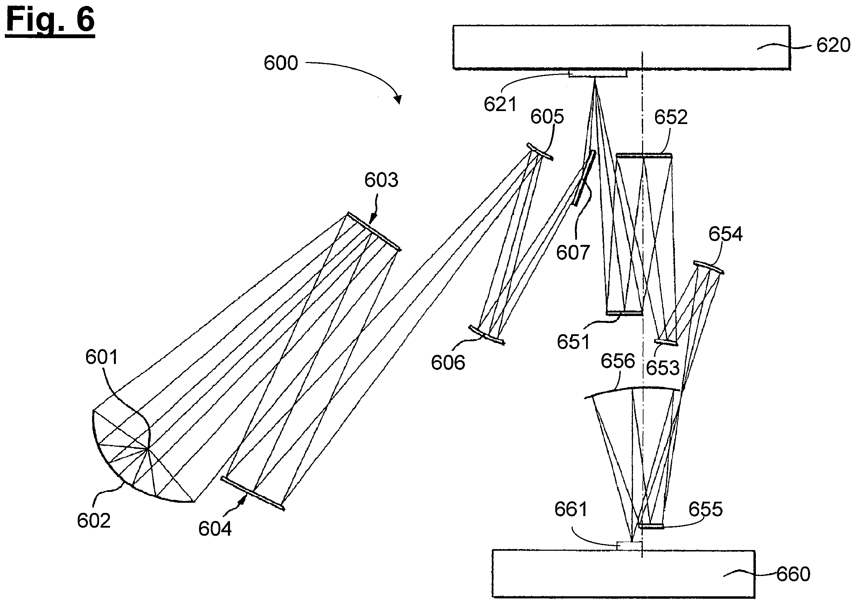

Fig. 6 zeigt eine schematische Darstellung einer beispielhaften für den Betrieb im EUV ausgelegten Projektionsbelichtungsanlage, in welcher die vorliegende Erfindung realisierbar ist.

Gemäß Fig. 6 weist eine Beleuchtungseinrichtung in einer für EUV ausgelegten Projektionsbelichtungsanlage 600 einen Feldfacettenspiegel 603 und einen Pupillenfacettenspiegel 604 auf. Auf den Feldfacettenspiegel 603 wird das Licht einer Lichtquelleneinheit, welche eine Plasmalichtquelle 601 und einen Kollektorspiegel 602 umfasst, gelenkt. Im Lichtweg nach dem Pupillenfacettenspiegel 604 sind ein erster Teleskopspiegel 605 und ein zweiter Teleskopspiegel 606 angeordnet. Im Lichtweg nachfolgend ist ein Umlenkspiegel 607 angeordnet, der die auf ihn treffende Strahlung auf ein Objektfeld in der Objektebene eines sechs Spiegel 651-656 umfassenden Projektionsobjektivs lenkt. Am Ort des Objektfeldes ist eine reflektive strukturtragende Maske 621 auf einem Maskentisch 620 angeordnet, die mit Hilfe des Projektionsobjektivs in eine Bildebene abgebildet wird, in welcher sich ein mit einer lichtempfindlichen Schicht (Photoresist) beschichtetes Substrat 661 auf einem Wafertisch 660 befindet.

Ohne dass die Erfindung hierauf beschränkt wäre, ist das erfindungsgemäße Verfahren insbesondere vorteilhaft auf die Fertigung des Feldfacettenspiegels 603 aus Fig. 6 anwendbar, weiter insbesondere dann, wenn die einzelnen Feldfacetten des Feldfacettenspiegels 603 ihrerseits aus einzelnen Spiegelelementen bzw. Mikrospiegeln zusammengesetzt sind.

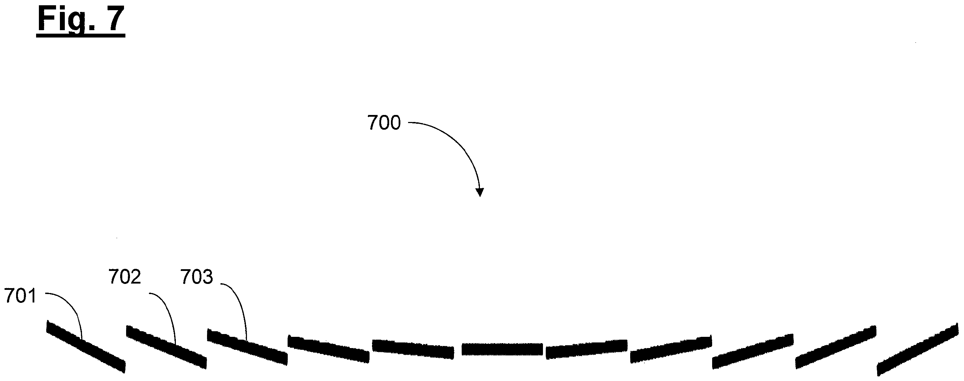

Eine solche "Sub-Facettierung" des Feldfacettenspiegels ist dem Fachmann als solche aus US 2011/0001947 A1 bekannt und kann wie in Fig. 7 anhand einer einzelnen Feldfacette 700 schematisch dargestellt z.B. derart erfolgen, dass eine Mehrzahl jeweils planer Spiegelelemente 701, 702, 703,... in solcher Weise durch entsprechende Einstellung der Normalen-Vektoren aneinandergereiht werden, dass im Ergebnis die typischerweise sphärische Oberfläche der (makroskopischen) Spiegelfacette nachgebildet wird. Dabei kann jedoch die optische Wirkung der Pupillenfacetten des Pupillenfacettenspiegels 604 aus Fig. 6 durch eine "falsche" Brechkraft der einzelnen Spiegelelemente 701, 702, 703,... bzw. der Feldfacetten 700 des Feldfacettenspiegels 603 aus Fig. 6 beeinträchtigt werden.

Eine Überwindung des vorstehenden Problems ist nun dadurch möglich, dass die einzelnen Spiegelelemente 701, 702, 703,... der Feldfacette 700 nicht plan, sondern mit einem geeigneten Krümmungsradius bzw. geeigneter Brechkraft gefertigt werden. Eine solche Krümmung bzw. Brechkraft der einzelnen Spiegelelemente 701, 702, 703,... lässt sich z.B. mittels Ionenbestrahlung oder Grauton-Lithographie erzielen, was jedoch (u.a. im Hinblick auf eine erforderliche Vereinzelung der Spiegelelemente 701, 702, 703,...) mit einem erhöhten Zeit- und Kostenaufwand verbunden ist. Die unter Bezugnahme auf Fig. 1-5 beschriebene Erzeugung definierter Krümmungsradien bzw. Brechkraft im Wege der Ausnutzung der im Beschichtungsprozess bei Aufbringung des Schichtstapels auf das jeweilige Substrat ausgeübten Biegekraft ist hier besonders geeignet, da der (ohnehin erforderliche und somit keinen zusätzlichen Fertigungsschritt erfordernde) Beschichtungsprozess einfach in geeigneter Weise ausgestaltet wird, um z.B. zunächst plane Substrate in der gewünschten Weise (insbesondere konkav) zu verformen.

Die Erfindung ist jedoch nicht auf die Anwendung auf den Facettenspiegel beschränkt, so dass grundsätzlich auch andere Spiegel (auch solche, die nicht aus einer Mehrzahl von Spiegelelementen zusammengesetzt sind) in der erfindungsgemäßen Weise ausgestaltet werden können.

Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind, und die Reichweite der Erfindung nur im Sinne der beigefügten Patentansprüche und deren Äquivalente beschränkt ist.

## Patentansprüche

1. Verfahren zum Herstellen eines Spiegelelements, wobei das Verfahren folgende Schritte aufweist:
a) Bereitstellen eines Substrats (101, 102, 103, 104, 201, 202, 301, 302, 401, 402, 501, 502, 801, 901, 951, 961); und
b) Ausbilden eines Schichtstapels (111, 112, 113, 114, 211, 212, 311, 312, 411, 412, 511, 512) auf dem Substrat, wobei dieser Schichtstapel zumindest ein Reflexionsschichtsystem aufweist;
c) wobei das Ausbilden des Schichtstapels (111, 112, 113, 114, 211, 212, 311, 312, 411, 412, 511, 512) derart erfolgt, dass eine für eine vorgegebene Betriebstemperatur gewünschte Soll-Krümmung des Spiegelelements durch eine von dem Schichtstapel ausgeübte Biegekraft erzeugt wird, wobei das Substrat vor dem Ausbilden des Schichtstapels eine von dieser Soll-Krümmung des Spiegelelements abweichende Krümmung besitzt, und wobei die von dem Schichtstapel ausgeübte Biegekraft zumindest teilweise dadurch erzeugt wird, dass eine Nachbehandlung zur Veränderung der Schichtspannung des Schichtstapels durchgeführt wird; **dadurch gekennzeichnet, dass** jeweils eine Mehrzahl von Spiegelelementen hergestellt wird, wobei sich wenigstens zwei dieser Spiegelelemente in der Soll-Krümmung voneinander unterscheiden;
wobei die Herstellung der Spiegelelemente mit voneinander verschiedener Soll-Krümmung dadurch erfolgt, dass entweder auf Substraten unterschiedlicher Dicke jeweils ein Schichtstapel unter Einstellung der gleichen, von dem jeweiligen Schichtstapel ausgeübten Biegekraft aufgebracht wird, oder dass auf Substraten gleicher Dicke jeweils ein Schichtstapel unter Einstellung unterschiedlicher, von dem jeweiligen Schichtstapel ausgeübter Biegekräfte aufgebracht wird.

2. Verfahren nach Anspruch 1, **dadurch gekennzeichnet, dass** durch die von dem Schichtstapel (111, 112, 113, 114, 211, 212, 311, 312, 411, 412, 511, 512) ausgeübte Biegekraft, insbesondere durch die Nachbehandlung zur Veränderung der Schichtspannung des Schichtstapels, eine irreversible Änderung der Krümmung bewirkt wird.

3. Verfahren nach Anspruch 1 oder 2, **dadurch gekennzeichnet, dass** diese Nachbehandlung auf einen oder mehrere Teilbereiche des Schichtstapels lokal begrenzt wird.

4. Verfahren nach einem der Ansprüche 1 bis 3, **dadurch gekennzeichnet, dass** das Substrat eine lokal variierende Steifigkeit aufweist, welche so gewählt ist, dass nach dem Ausbilden des Schichtstapels die für die vorgegebene Betriebstemperatur gewünschte Soll-Krümmung des Spiegelelements erzielt wird.

5. Verfahren nach Anspruch 4, **dadurch gekennzeichnet, dass** das Substrat aus einem ersten Material hergestellt ist, wobei die Steifigkeit zumindest teilweise durch Dotierung mit Fremdatomen eines von dem ersten Material verschiedenen zweiten Materials bewirkt wird.

6. Verfahren nach einem der vorhergehenden Ansprüche, **dadurch gekennzeichnet, dass** der Schichtstapel (111, 112, 113, 114, 211, 212, 311, 312, 411, 412, 511, 512) zwischen dem Reflexionsschichtsystem und dem Substrat (101, 102, 103, 104, 201, 202, 301, 302, 401, 402, 501, 502, 801, 901, 951, 961) eine zusätzliche spannungsinduzierende Schicht aufweist.

7. Verfahren nach einem der vorhergehenden Ansprüche, **dadurch gekennzeichnet, dass** für eine Betriebstemperatur von wenigstens 100°C die gewünschte Soll-Krümmung des Spiegelelements eine konkave Krümmung ist.

8. Verfahren nach einem der vorhergehenden Ansprüche, **dadurch gekennzeichnet, dass** das Spiegelelement ein Spiegelelement einer aus einer Mehrzahl von Spiegelelementen zusammengesetzten Spiegelanordnung ist.

9. Verfahren nach Anspruch 8, **dadurch gekennzeichnet, dass** die Spiegelanordnung ein Facettenspiegel, insbesondere ein Feldfacettenspiegel oder ein Pupillenfacettenspiegel, ist.

10. Verfahren nach einem der vorhergehenden Ansprüche, **dadurch gekennzeichnet, dass** das Spiegelelement ein Spiegelelement einer mikrolithographischen Projektionsbelichtungsanlage ist.

## Claims

1. Method for producing a mirror element, wherein the method comprises the following steps:
a) providing a substrate (101, 102, 103, 104, 201, 202, 301, 302, 401, 402, 501, 502, 801, 901, 951, 961); and
b) forming a layer stack (111, 112, 113, 114, 211, 212, 311, 312, 411, 412, 511, 512) on the substrate, wherein this layer stack has at least one reflection layer system;
c) wherein the layer stack (111, 112, 113, 114, 211, 212, 311, 312, 411, 412, 511, 512) is formed in such a way that a setpoint curvature of the mirror element wanted for a predetermined operating temperature is generated by a bending force exerted by the layer stack, wherein the substrate has a curvature deviating from this setpoint curvature of the mirror element prior to the formation of the layer stack, and wherein the bending force exerted by the layer stack is at least partly generated by virtue of a post-treatment for changing the layer tension of the layer stack being carried out; **characterized in that**
a plurality of mirror elements are produced in each case, wherein at least two of these mirror elements differ from one another in terms of the setpoint curvature;
wherein the production of the mirror elements with mutually different setpoint curvatures is carried out by virtue of a layer stack being applied to substrates with different thicknesses in each case, with the same bending force exerted by the respective layer stack being set, or by virtue of a layer stack being applied to substrates with the same thickness in each case, with different bending forces exerted by the respective layer stack being set.

2. Method according to Claim 1, **characterized in that** the bending force exerted by the layer stack (111, 112, 113, 114, 211, 212, 311, 312, 411, 412, 511, 512), in particular the post-treatment for changing the layer tension of the layer stack, brings about an irreversible change in the curvature.

3. Method according to either of Claims 1 and 2, **characterized in that** this post-treatment is locally restricted to one or more portions of the layer stack.

4. Method according to any one of Claims 1 to 3, **characterized in that** the substrate has a locally varying rigidity, which is selected in such a way that the setpoint curvature of the mirror element wanted for the predetermined operating temperature is obtained after the formation of the layer stack.

5. Method according to Claim 4, **characterized in that** the substrate is produced from a first material, wherein the rigidity is caused at least in part by doping with foreign atoms of a second material which differs from the first material.

6. Method according to any one of the preceding claims, **characterized in that** the layer stack (111, 112, 113, 114, 211, 212, 311, 312, 411, 412, 511, 512) has an additional tension-inducing layer between the reflection layer system and the substrate (101, 102, 103, 104, 201, 202, 301, 302, 401, 402, 501, 502, 801, 901, 951, 961).

7. Method according to any one of the preceding claims, **characterized in that** the wanted setpoint curvature of the mirror element is a concave curvature for an operating temperature of at least 100°C.

8. Method according to any one of the preceding claims, **characterized in that** the mirror element is a mirror element of a mirror arrangement composed of a plurality of mirror elements.

9. Method according to Claim 8, **characterized in that** the mirror arrangement is a facet mirror, in particular a field facet mirror or a pupil facet mirror.

10. Method according to one of the preceding claims, **characterized in that** the mirror element is a mirror element of a microlithographic projection exposure apparatus.

## Revendications

1. Procédé de fabrication d'un élément de miroir, le procédé comprenant les étapes suivantes :
a) préparation d'un substrat (101, 102, 103, 104, 201, 202, 301, 302, 401, 402, 501, 502, 801, 901, 951, 961) ; et
b) réalisation d'une superposition de couches (111, 112, 113, 114, 211, 212, 311, 312, 411, 412, 511, 512) sur le substrat, dans lequel cette superposition de couches comporte au moins un système de couche réfléchissante ;
c) dans lequel la réalisation de la superposition de couches (111, 112, 113, 114, 211, 212, 311, 312, 411, 412, 511, 512) s'effectue de sorte qu'une courbure de consigne de l'élément de miroir souhaitée pour une température de fonctionnement prédéfinie est obtenue par une force de flexion exercée par la superposition de couches, dans lequel le substrat possède, avant la réalisation de la superposition de couches, une courbure différente de cette courbure de consigne de l'élément de miroir, et dans lequel la force de flexion exercée par la superposition de couches est obtenue au moins partiellement en mettant en oeuvre un traitement postérieur de modification de la tension de couche de la superposition de couches ;
**caractérisé en ce que** qu'une pluralité d'éléments de miroir sont respectivement fabriqués, dans lequel au moins deux de ces éléments de miroir diffèrent l'un de l'autre par leur courbure de consigne ;
dans lequel la fabrication des éléments de miroir avec des courbures de consigne différentes l'une de l'autre s'effectue ou bien en déposant sur les substrats différentes épaisseurs respectivement d'une superposition de couches tout en réglant la force de flexion identique exercée par la superposition de couches respective, ou bien en déposant sur les substrats des épaisseurs identiques respectivement d'une superposition de couches tout en réglant les forces de flexion différentes exercées par la superposition de couches respective.

2. Procédé selon la revendication 1, **caractérisé en ce qu'**une modification irréversible de la courbure est opérée par la force de flexion exercée par la superposition de couches (111, 112, 113, 114, 211, 212, 311, 312, 411, 412, 511, 512), en particulier par le traitement postérieur de modification de la tension de couche de la superposition de couches.

3. Procédé selon la revendication 1 ou 2, **caractérisé en ce que** ce traitement postérieur est délimité localement sur une ou plusieurs zones de la superposition de couches.

4. Procédé selon l'une des revendications 1 à 3, **caractérisé en ce que** le substrat possède une rigidité localement variable, laquelle est choisie de sorte qu'après la réalisation de la superposition de couches, la courbure de consigne de l'élément de miroir souhaitée pour une température de fonctionnement prédéfinie est atteinte.

5. Procédé selon la revendication 4, **caractérisé en ce que** le substrat est fabriqué en un premier matériau, dans lequel la rigidité est opérée au moins partiellement par dopage avec des atomes étrangers d'un deuxième matériau différent du premier matériau.

6. Procédé selon l'une des revendications ci-dessus, **caractérisé en ce que** la superposition de couches (111, 112, 113, 114, 211, 212, 311, 312, 411, 412, 511, 512) comporte une couche supplémentaire induisant une tension entre le système de couches réfléchissantes et le substrat (101, 102, 103, 104, 201, 202, 301, 302, 401, 402, 501, 502, 801, 901, 951, 961).

7. Procédé selon l'une des revendications ci-dessus, **caractérisé en ce que** pour une température de fonctionnement d'au moins 100 °C la courbure de consigne souhaitée de l'élément de miroir est une courbure concave.

8. Procédé selon l'une des revendications ci-dessus, **caractérisé en ce que** l'élément de miroir est un élément de miroir d'un arrangement de miroir composé d'une pluralité d'éléments de miroir.

9. Procédé selon la revendication 8, **caractérisé en ce que** l'arrangement de miroir est un miroir à facettes, en particulier un miroir à facettes de champ ou un miroir à facettes à pupilles.

10. Procédé selon l'une des revendications ci-dessus, **caractérisé en ce que** l'élément de miroir est un élément de miroir d'un système d'exposition microlithographique.
